# EUROPEAN PATENT APPLICATION

(11) **EP 4 712 129 A1**
(43) Date of publication of application: **18.03.2026**
(21) Application number: 24806810.8
(22) Date of filing: 09.01.2024
(51) Int. Cl.: H01L 21/56, B29C 43/18, B29C 43/32, H01L 23/28

(54) **FORMATION DEVICE FOR SEALING RESIN THAT IS USED FOR COMPRESSION MOLDING**

(30) Priority: 12.05.2023 JP 2023079106
(71) Applicant: Yamaha Robotics Co., Ltd., Musashimurayama-shi, Tokyo 208-8585 (JP)
(72) Inventor: OGUCHI Tatsushi, Chikuma-shi, Nagano 389-0898 (JP)
(74) Representative: Becker, Eberhard
(86) International application number: PCT/JP2024/000120
(87) International publication number: WO 2024/236855

(57) **Abstract**

The present invention addresses the problem of providing a formation device that is capable of forming a sealing resin with which it is possible to achieve a compression molding device and a compression molding method that are capable of preventing the occurrence of molding failure, the formation device being also capable of preventing the occurrence of a cracking loss of a sealing resin during the formation process. As a solution, a sealing resin formation device (100) according to the present invention is for forming a sealing resin (R) that is used for compression molding of a workpiece (W), the formation device being provided with: a forming die (102) that has a pair of a lower die (106) and an upper die (104) which are opened and closed, the forming die housing and applying heat and pressure to a base resin (Rm) in a state in which a release film (F) is interposed, thereby forming a sealing resin (R) that has a predetermined shape; and a film separation mechanism (170) that separates the release film (F) from the formed sealing resin (R).

## Description

### Technical Field

The present invention relates to a sealing resin formation device that is used for compression molding.

### Related Art

As an example of a resin sealing device and resin sealing method for sealing a workpiece having electronic components mounted on a base material with sealing resin to process it into a molded product, a compression molding system is known.

The compression molding system is a technology for resin sealing by supplying a predetermined amount of sealing resin to a sealing region (cavity) provided in a sealing mold configured to include an upper mold and a lower mold, placing a workpiece in the sealing region, and clamping with the upper mold and the lower mold. As an example, in the case of using a sealing mold having a cavity provided in the upper mold, a technology for molding by collectively supplying sealing resin to a center position on the workpiece is known. On the other hand, in the case of using a sealing mold having a cavity provided in the lower mold, a technology for molding by supplying a release film (hereinafter sometimes simply referred to as "film") and sealing resin that cover a mold surface including the cavity is known (Patent Document 1: see Japanese Patent Application Laid-Open Publication No. 2019-145550).

### Citation List

### Patent Literature

Patent Document 1: Japanese Patent Application Laid-Open Publication No. 2019-145550

### SUMMARY OF INVENTION

### Technical Problem

For example, in the case of resin sealing of strip type wire-connected electronic components (semiconductor chips) as a workpiece, in a compression molding system where a cavity is provided in an upper mold, there was a problem that resin sealing was difficult because wire portions of the workpiece held by the lower mold would contact and deform with sealing resin supplied in advance to the cavity or sealing resin supplied on the workpiece. Therefore, generally, a compression molding system was adopted in which the workpiece is held by the upper mold, a cavity is provided in the lower mold, and sealing resin (as an example, granular resin) is supplied into the cavity.

However, in a configuration where the workpiece is held by the upper mold and a cavity is provided in the lower mold, there was a problem that in the case of a thin or large workpiece, holding by the upper mold was difficult and dropping was likely to occur. Also, normally, a configuration is adopted where sealing resin is supplied into the cavity of the lower mold with a film interposed, but in attempting to form a molded product thick enough that the thickness (here, the thickness of the resin portion after molding) exceeds about 1 mm, there was a problem that the molding stroke becomes large and molding defects where the film bites into the molded product are likely to occur. Furthermore, in the case of using granular resin as the sealing resin, the bulk increases due to the diameter of the granular resin, making the aforementioned film biting more likely to occur, and in addition to problems of dust generation during molding due to friction between granular resins during movement and difficulty in handling, there was a problem that it was difficult to supply (scatter) sealing resin evenly to all regions within the cavity provided in the lower mold, making scattering unevenness likely to occur. Also, there was a problem that molding defects were likely to occur where air contained in gaps between particles during scattering of sealing resin and gas components from defoaming from the sealing resin during melting could not escape and remained as voids or the like in the molded product. Particularly, in the case of a workpiece on which electronic components are mounted by wire connection, there was also a possibility that wire flow (wire deformation, cutting) due to resin flow within the cavity during resin sealing could occur.

Also, since the sealing resin used in compression molding is naturally in a state before full curing, it has low rigidity (is brittle) and weak strength, so there was a problem that cracking damage was likely to occur during the formation process and the like.

### Solution to Problem

The present invention is made in view of the above circumstances, and aims to provide a formation device and formation method for forming a sealing resin that is a sealing resin with easy handling, and that enables problem solving for configurations where a cavity is provided in an upper mold and problem solving for configurations where a cavity is provided in a lower mold, prevention of occurrence of molding defects due to resin flow, scattering unevenness, residual gas, and dust generation during molding, and formation of molded products with large thickness dimensions, thereby realizing a compression molding device and compression molding method. In addition to this, the aim is to prevent occurrence of cracking damage of the sealing resin during the formation process. Particularly, since cracking damage is likely to occur in peeling a release film stuck to the sealing resin, solving this becomes an issue.

The present invention solves the aforementioned problems by solution means as described below as one embodiment.

A sealing resin formation device according to one embodiment is a formation device that forms a sealing resin used for compression molding of a workpiece, and is required to include: a forming mold that has a pair of lower mold and upper mold that are opened and closed, and that accommodates, and heats and pressurizes a base resin in a state where a release film is interposed, so as to form the sealing resin of a predetermined shape; and a film peeling mechanism that peels the release film from the formed sealing resin.

For example, a powder resin is used as the base resin, and the forming mold is a tableting mold that tablets the powder resin.

Also, it is preferable that the forming mold is set to a heating temperature at which the base resin does not thermally cure, such that the formed sealing resin is capable of thermal curing in a case of being used for compression molding of the workpiece.

Also, it is preferable that the film peeling mechanism has a grip part that grips one end of the release film and moves toward the other end.

Also, it is preferable that the film peeling mechanism has a tension roller that, in response to the grip part gripping the one end of the release film and moving toward the other end, brings the release film into rolling contact or sliding contact with a part of a peripheral surface to apply tension to the release film while performing a linear movement in a same direction as a movement direction of the grip part.

Also, it is preferable that the film peeling mechanism has a tension part that rotatably supports the tension roller and applies resistance to restrict the linear movement of the tension roller.

Also, it is preferable that the tension part is configured to have a linear motion mechanism using an air cylinder or an electric motor, and the resistance is set by the linear motion mechanism or is variably controlled.

Also, it is preferable that the film peeling mechanism has a suction stage provided with a suction part that suctions the sealing resin on one of an upper surface or a lower surface, and the grip part and the tension roller are arranged on a same side as a surface on which the suction part is provided with respect to the suction stage.

Also, it is preferable to further include an inversion mechanism that inverts the sealing resin such that an upper and a lower surface of the sealing resin are reversed.

### Effects of Invention

According to the formation device related to the present invention, it is possible to form sealing resin that enables realization of a compression molding device and compression molding method that achieve the following effects. Specifically, in the compression molding device and compression molding method, it is possible to solve the problems of a configuration in which a cavity is provided in an upper mold and solve the problems of a configuration in which a cavity is provided in a lower mold. Also, it is possible to prevent occurrence of molding defects caused by resin flow, scattering unevenness, residual gas, and dust generation during molding. Also, it is possible to form not only molded products with small (thin) thickness dimensions but also molded products with large (thick) thickness dimensions. Also, handling becomes easier particularly during supply or setting compared to granular resin and the like.

Also, according to the above formation device, it is possible to prevent occurrence of cracking in the sealing resin in the case of peeling the release film stuck to the sealing resin during the formation process.

### BRIEF DESCRIPTION OF DRAWINGS

[FIG. 1] FIG. 1 is a plan view showing an example of a compression molding device in which sealing resin formed by a formation device and formation method according to an embodiment of the present invention is used.
[FIG. 2] FIG. 2 is an explanatory diagram that describes an example of a compression molding method in which sealing resin formed by a formation device and formation method according to an embodiment of the present invention is used.
[FIG. 3] FIG. 3A is an enlarged view of part III in FIG. 2. FIG. 3B is an explanatory diagram following FIG. 3A.
[FIG. 4] FIG. 4 is an explanatory diagram following FIG. 3B.
[FIG. 5] FIG. 5 is an explanatory diagram following FIG. 4.
[FIG. 6] FIG. 6 is an explanatory diagram that describes another example of a compression molding method in which sealing resin formed by a formation device and formation method according to an embodiment of the present invention is used.
[FIG. 7] FIG. 7 is an explanatory diagram following FIG. 6.
[FIG. 8] FIG. 8 is an explanatory diagram following FIG. 7.
[FIG. 9] FIG. 9 is a plan view showing an example of a sealing resin formation device according to an embodiment of the present invention.
[FIG. 10] FIG. 10 is a front view showing an example of a press device of the formation device shown in FIG. 9.
[FIG. 11] FIG. 11 is a front cross-sectional view showing an example of a tableting mold of the formation device shown in FIG. 9.
[FIG. 12] FIG. 12 is a plan view showing an example of a resin guard of the formation device shown in FIG. 9.
[FIG. 13] FIG. 13 is a front view showing an example of a film peeling mechanism of the formation device shown in FIG. 9.
[FIG. 14] FIG. 14 is an explanatory diagram of a sealing resin formation method according to an embodiment of the present invention.
[FIG. 15] FIG. 15 is an explanatory diagram continuing from FIG. 14.
[FIG. 16] FIG. 16 is an explanatory diagram continuing from FIG. 15.
[FIG. 17] FIG. 17 is a perspective view showing an example of a sealing resin formed by the formation device and formation method according to an embodiment of the present invention.
[FIG. 18] FIG. 18 is a perspective view showing another example of a sealing resin formed by the formation device and formation method according to an embodiment of the present invention.
[FIG. 19] FIG. 19 is a perspective view showing another example of a sealing resin formed by the formation device and formation method according to an embodiment of the present invention.
[FIG. 20] FIG. 20 is a perspective view showing another example of a sealing resin formed by the formation device and formation method according to an embodiment of the present invention.
[FIG. 21] FIG. 21 is an explanatory diagram of a conventional compression molding method.
[FIG. 22] FIG. 22 is an explanatory diagram of a conventional compression molding method.

### DESCRIPTION OF THE EMBODIMENTS

### (Compression Molding Device and Compression Molding Method)

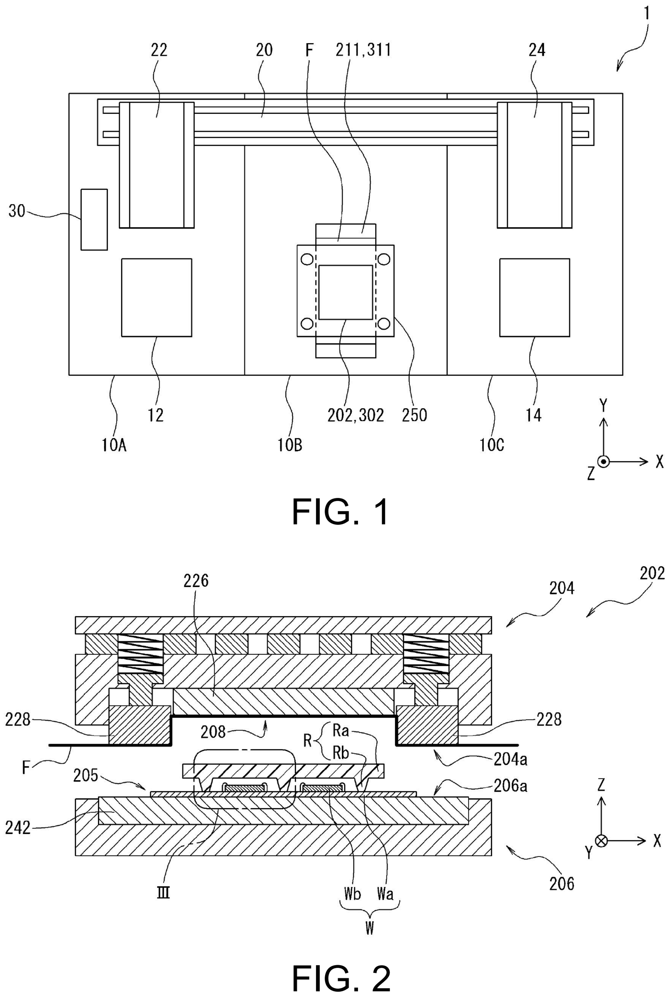

A sealing resin formation device 100 and formation method according to an embodiment of the present invention are a device and method for forming a sealing resin R used for compression molding of a workpiece W. First, an outline of a compression molding device 1 and compression molding method that perform resin sealing (compression molding) of the workpiece W using the sealing resin R will be described. Here, FIG. 1 is a plan view (schematic diagram) showing an example of the compression molding device 1. For convenience of explanation, arrows may indicate the left-right direction (X direction), front-back direction (Y direction), and up-down direction (Z direction) in the figures. In all figures for describing each embodiment, members having the same function are given the same reference numerals, and repeated descriptions thereof may be omitted.

The workpiece W to be sealed has a configuration in which electronic components Wb are mounted on a base material Wa. More specifically, examples of the base material Wa include plate-shaped members such as resin substrates, ceramic substrates, metal substrates, carrier plates, lead frames, wafers, and the like. Examples of the electronic components Wb include semiconductor chips, MEMS chips, passive elements, heat dissipation plates, conductive members, spacers, and the like. The shape of the base material Wa is rectangular (strip-shaped), square, circular, or the like. The number of electronic components Wb mounted on one base material Wa is set to one or multiple (for example, in a matrix arrangement, etc.).

Examples of methods for mounting the electronic components Wb on the base material Wa include wire bonding mounting, flip chip mounting, and the like. Alternatively, in the case of a configuration where the base material (glass or metal carrier plate) Wa is peeled from the molded product Wp after resin sealing, there is also a method of attaching the electronic components Wb using thermally peelable adhesive tape or ultraviolet curable resin that cures upon ultraviolet irradiation.

Examples of a film F include film materials excellent in heat resistance, easy peelability, flexibility, and extensibility, such as PTFE (polytetrafluoroethylene), ETFE (polytetrafluoroethylene polymer), PET, FEP, fluorine-impregnated glass cloth, polypropylene, polyvinylidene chloride, and the like, which are suitably used. The film F is also used in forming the sealing resin R in the formation device 100 described later.

As shown in FIG. 1, the compression molding device 1 includes as main components a supply unit 10A that performs supply of the workpiece W and the like, a press unit 10B that performs resin sealing of the workpiece W and processing into the molded product Wp and the like, and a storage unit 10C that performs storage of the molded product Wp and the like. As an example, the supply unit 10A, the press unit 10B, and the storage unit 10C are arranged in this order along the X direction in FIG. 1. However, the configuration is not limited to the above, and the equipment configuration within the units, the number of units (particularly, the number of press units), the arrangement order of the units, and the like may be changed. A configuration including units other than the above may also be adopted (all not shown).

The compression molding device 1 is provided with a guide rail 20 linearly extending across the units, and a transport device (first loader) 22 that transports the workpiece W and the sealing resin R, and a transport device (second loader) 24 that transports the molded product Wp (which may also be used for transporting the sealing resin R) are provided to be movable between predetermined units along the guide rail 20. However, the configuration is not limited to the above, and a configuration including a common (single) transport device (loader) that transports the workpiece W, the sealing resin R, and the molded product Wp may be adopted (not shown). The transport device may also be configured to include a robot hand or the like instead of the loader.

The compression molding device 1 has a control part 30 that performs operation control of each mechanism in each unit arranged in the supply unit 10A (may be configured to be arranged in other units).

The press unit 10B includes a pair of sealing molds that are opened and closed by a press device 250. The sealing mold may be configured, as an example, to have a cavity provided in an upper mold (sealing mold 202), or as another example, to have a cavity provided in a lower mold (sealing mold 302).

As an example, the steps of a compression molding method implemented using the compression molding device 1 in the case of including the sealing mold 202 will be described with reference to FIG. 2 to FIG. 5. In this case, the press device 250 is provided with a film supply part 211 that supplies a film F for covering a mold surface 204a (predetermined region) including an inner surface of a cavity 208 in an upper mold 204. As an example, the film F is in a roll shape but may be in a strip shape.

First, a preparation step (sealing preparation step) is implemented. Specifically, a step of adjusting and heating the upper mold 204 and a lower mold 206 to a predetermined temperature (for example, 100°C to 300°C) is implemented. In addition, a step of operating the film supply part 211 to supply a new film F and causing it to be attracted to cover a predetermined region of the mold surface 204a including an inner surface of the cavity 208 in the upper mold 204 is implemented.

After the preparation step, a workpiece holding step of holding the workpiece W in a workpiece holding part 205 of the lower mold 206 is implemented. Specifically, the workpiece W supplied from a supply magazine 12 is held by the first loader 22 and carried into the sealing mold 202, and held in the workpiece holding part 205 of a lower plate 242 (mold surface 206a).

After the workpiece holding step, a resin placement step of placing the sealing resin R on the workpiece W held in the workpiece holding part 205 is implemented (see FIG. 2). Specifically, the sealing resin R formed in a sealing resin formation device (may be simply referred to as "formation device") 100 described later is held by the first loader 22 (other transport devices may be used) and carried into the sealing mold 202, and placed on the workpiece W held in the workpiece holding part 205.

Alternatively, as another example of the resin placement step, it may be implemented as a step of placing the sealing resin R formed in the formation device 100 on the workpiece W before the above-mentioned workpiece holding step. In that case, the workpiece holding step becomes a step of holding the workpiece W with the sealing resin R placed thereon in the workpiece holding part 205. That is, the first loader 22 holds the workpiece W with the sealing resin R placed thereon and carries it into the sealing mold 202, and holds it in the workpiece holding part 205. There is an advantage of carrying the workpiece W and sealing resin R into the sealing mold 202 in one operation rather than carrying them separately.

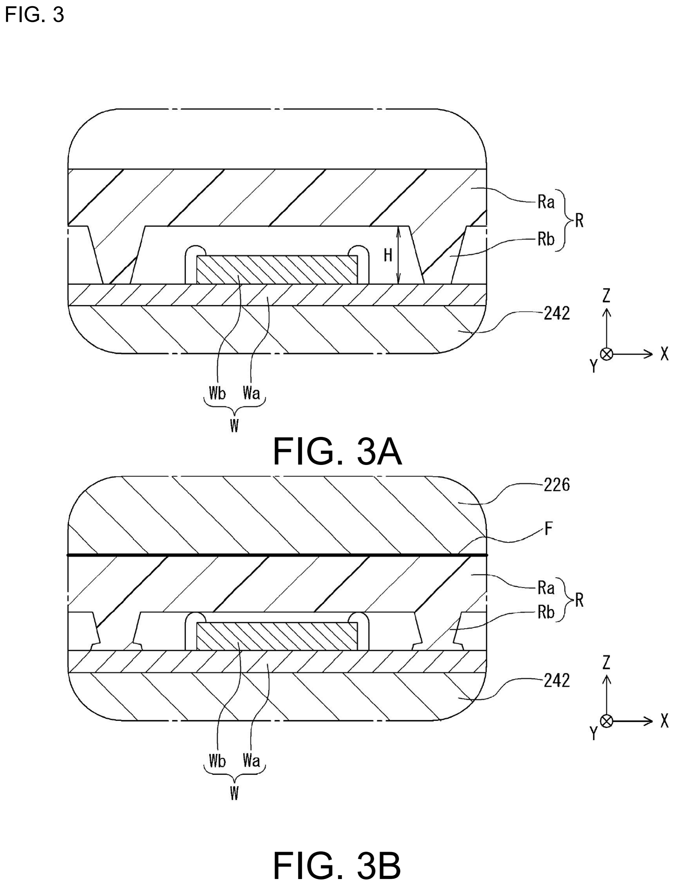

Next, a resin sealing step of sealing the workpiece W with the sealing resin R to process it into a molded product Wp is implemented. Specifically, a mold closing step of performing mold closing of the sealing mold 202 and relatively lowering the cavity piece 226 within the cavity 208 surrounded by a clamper 228 to apply heating and pressurization to the sealing resin R against the workpiece W is implemented. Moreover, FIG. 3A is an enlarged view of part III in FIG. 2, and softening and melting of the sealing resin R progresses from the state of FIG. 3A to the state of FIG. 3B in the mold closing step.

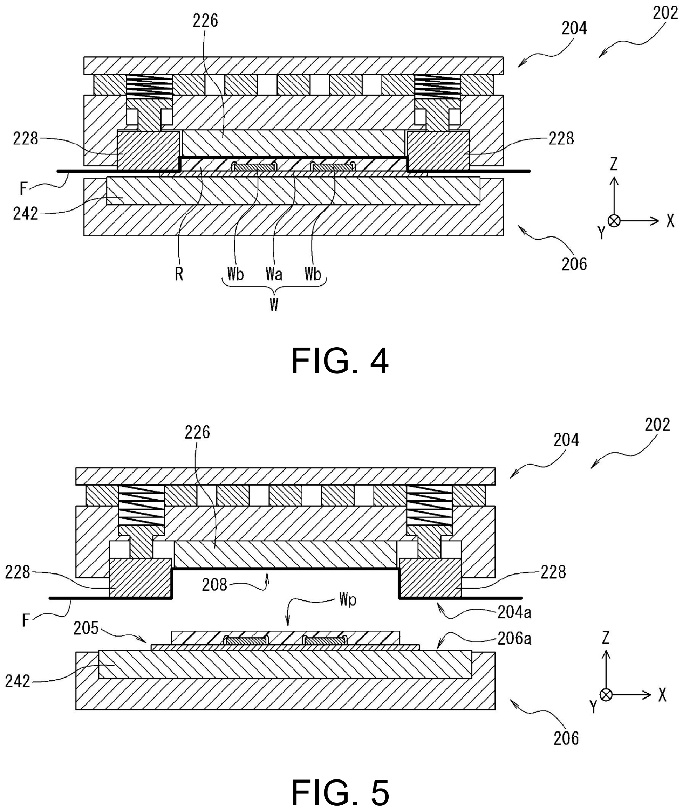

As a result, the sealing resin R is thermally cured and resin sealing (compression molding) is completed (see FIG. 4).

Moreover, the subsequent steps following the above mold closing step are the same as in conventional compression molding methods. In outline, a mold opening step of performing mold opening of the sealing mold 202 and separating the molded product Wp from the used film F to enable removal of the molded product Wp is implemented (see FIG. 5). Next, a molded product removal step of carrying out the molded product Wp from within the sealing mold 202 by the second loader 24 and transporting it to the storage unit 10C is implemented. As an example, the transported molded product Wp is stored in a storage magazine 14. Also, after the molded product removal step, or in parallel, a step of operating the film supply part 211 to send out the used film F from within the sealing mold 202 and feeding and setting a new film F into the sealing mold 202 is implemented.

The above are the main steps of the compression molding method performed using the compression molding device 1 in the case of including the sealing mold 202. However, the above step sequence is an example, and changes in the order of precedence or parallel implementation are possible as long as there is no hindrance.

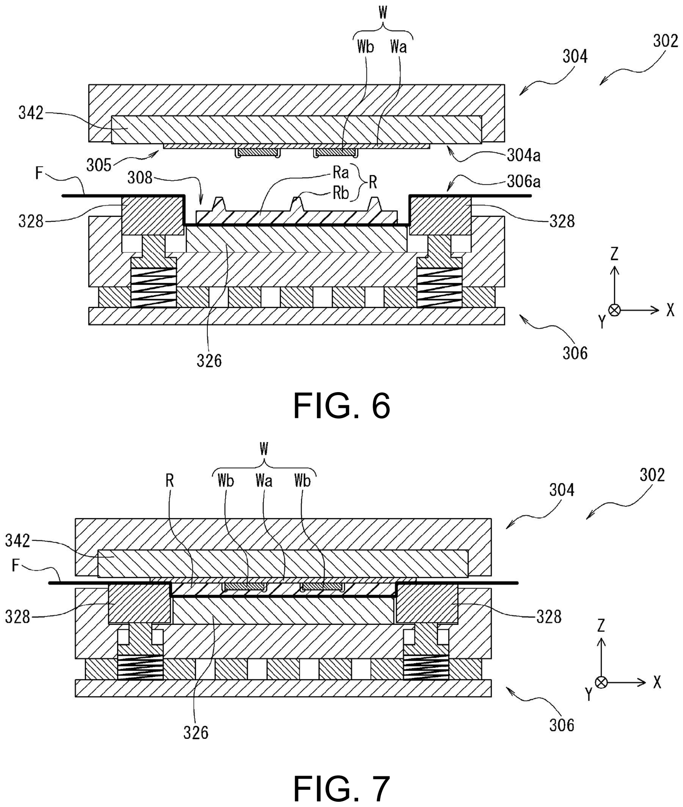

As another example, steps of a compression molding method implemented using the compression molding device 1 in the case of including the sealing mold 302 will be described with reference to FIG. 6 to FIG. 8. In this case, the press device 250 is provided with a film supply part 311 that supplies a film F for covering a mold surface 306a (predetermined region) including an inner surface of a cavity 308 in a lower mold 306. Moreover, as an example, the film F is in a roll shape but may be in a strip shape.

First, a preparation step (sealing preparation step) is implemented. Specifically, a step of adjusting and heating an upper mold 304 and the lower mold 306 to a predetermined temperature (for example, 100°C to 300°C) is implemented. Also, a step of operating the film supply part 311 to supply a new film F and causing it to be adsorbed so as to cover a predetermined region of the mold surface 306a including an inner surface of the cavity 308 in the lower mold 306 is implemented.

After the preparation step, a workpiece holding step of causing the workpiece W to be held by a workpiece holding part 305 of the upper mold 304 is implemented. Specifically, the workpiece W supplied from the supply magazine 12 is held by the first loader 22 and carried into the sealing mold 302, and is held by the workpiece holding part 305 of an upper plate 342 (mold surface 304a).

After the workpiece holding step, a resin holding step is implemented (moreover, it may be implemented before the workpiece holding step or in parallel). The resin holding step includes the following steps. The sealing resin R is held within the cavity 308 of the lower mold 306 (see FIG. 6). Specifically, the sealing resin R formed in the formation device 100 is held by the first loader 22 (other transport devices may be used) and carried into the sealing mold 302, and accommodated within the cavity 308 (specifically, placed on the upper surface of the cavity piece 326).

Next, a resin sealing step of sealing the workpiece W with the sealing resin R to process it into a molded product Wp is implemented. Specifically, a mold closing step is implemented in which the sealing mold 302 is closed, the cavity piece 326 is relatively raised within the cavity 308 surrounded by a clamper 328, and the sealing resin R is heated and pressurized against the workpiece W. As a result, the sealing resin R is thermally cured and resin sealing (compression molding) is completed (see FIG. 7).

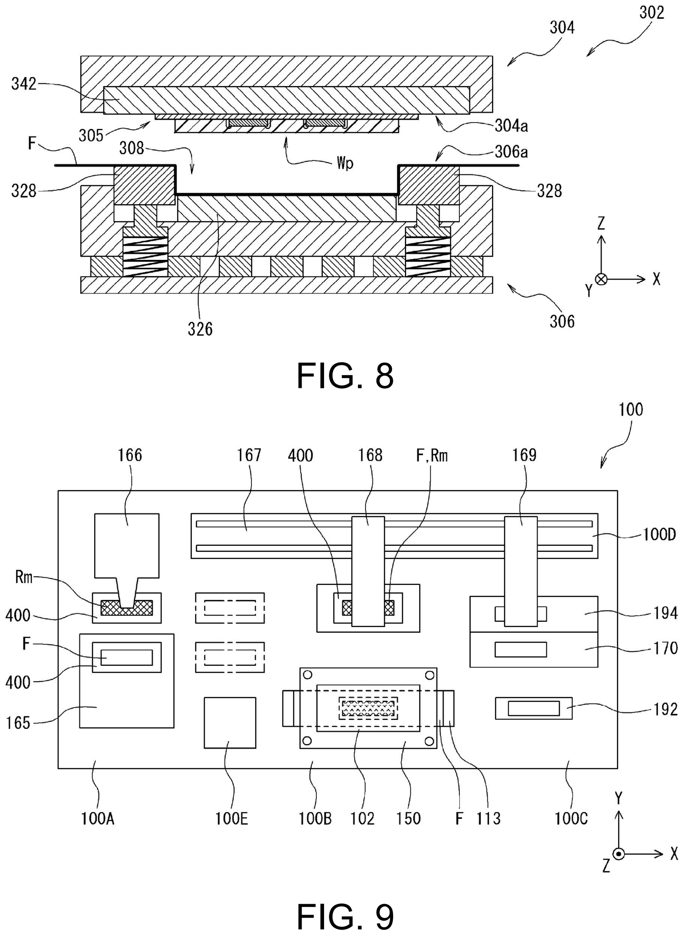

Moreover, the subsequent steps following the above mold closing step are the same as in conventional compression molding methods. In outline, a mold opening step is implemented in which the sealing mold 302 is opened and the molded product Wp and the used film F are separated such that the molded product Wp may be removed (see FIG. 8). Next, a molded product removal step is implemented in which the molded product Wp is carried out from within the sealing mold 302 by the second loader 24 and transported to the storage unit 10C. As an example, the transported molded product Wp is stored in the storage magazine 14. Also, after the molded product removal step, or in parallel, a step is implemented in which the film supply part 311 is operated to send out the used film F from within the sealing mold 302 and send in and set a new film F into the sealing mold 302.

The above are the main steps of the compression molding method performed using the compression molding device 1 in the case of including the sealing mold 302. However, the above step sequence is an example, and changes in the order of precedence or parallel implementation are possible as long as there is no hindrance.

### (Sealing Resin Formation device)

Next, the formation device 100 that forms the sealing resin R used in the above compression molding device 1 and compression molding method will be described with reference to FIG. 9 to FIG. 13. The formation device 100 processes a base resin Rm to form the sealing resin R. Here, FIG. 9 is a plan view (schematic diagram) showing an example of the formation device 100. Moreover, the formation device 100 may be provided either inside or outside the compression molding device 1.

In the present embodiment, a thermosetting resin (for example, a filler-containing epoxy resin, but not limited thereto) is used as the base resin Rm and the sealing resin R formed from the base resin Rm. The sealing resin R is formed as a solid/semi-solid resin having a predetermined shape (details will be described later) in which the overall shape corresponds to the shape of the workpiece W. Normally, one piece constitutes the "entirety" of the sealing required amount (one portion per workpiece W), but it may be configured such that several pieces (for example, about two or three pieces) in a divided state constitute the "entirety" of the sealing required amount. Also, the above "semi-solid" refers to a state that is not a completely solid state but is melted to the so-called B-stage. Moreover, powder resin (powdered resin form) that is a thermosetting resin (property) is suitably used for the base resin Rm. However, it is not limited thereto, and a configuration may be adopted in which granular resin, crushed resin, solid resin, liquid resin, or a resin combining multiple of these is used.

As shown in FIG. 9, the formation device 100 includes as main components: a supply part 100A that performs supply of the base resin Rm; a formation part 100B that performs formation of the sealing resin R from the base resin Rm; a storage part 100C that performs film peeling and storage of the formed sealing resin R; a transport part 100D that transports the base resin Rm and the sealing resin R; and a control calculation part 100E that performs operation control of each mechanism.

First, the transport part 100D includes, as an example, a guide rail 167 laid between the supply part 100A to the storage part 100C, and a first transport device (loader) 168 that moves on the guide rail 167 and transports the base resin Rm, and a second transport device (loader) 169 that transports the sealing resin R. However, the present invention is not limited to the above configuration, and may be configured to include a common (single) transport device (loader) that transports the base resin Rm and the sealing resin R. Also, the transport devices (loaders) 168, 169 are configured to be movable in the X direction and Y direction, but may be configured to separately include a transport device that moves in the X direction and a transport device that moves in the Y direction. Also, the transport device may be configured to include a robot hand or the like instead of a loader (all not shown).

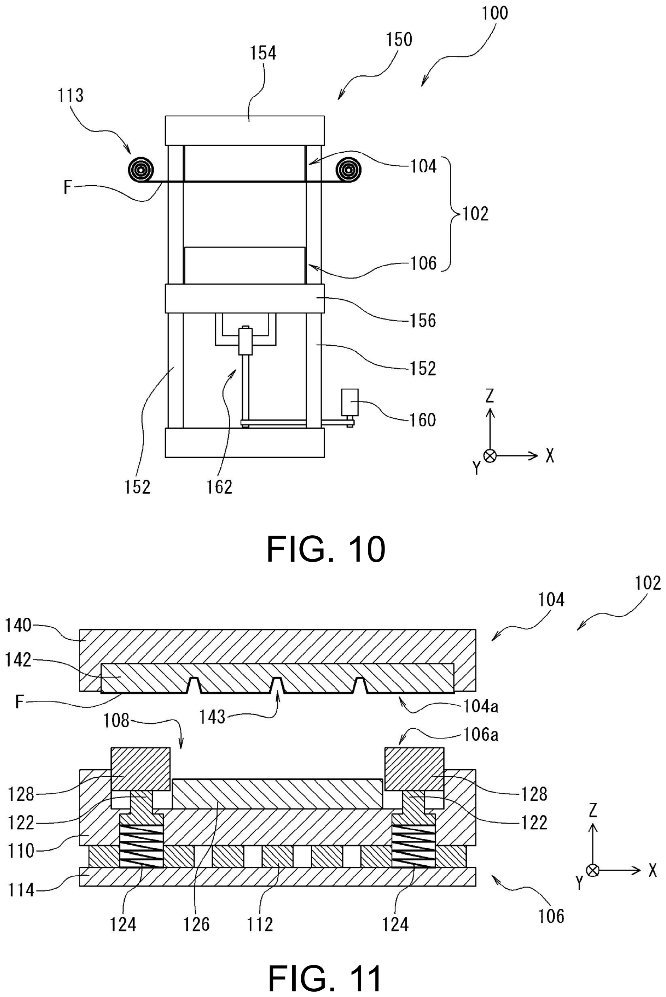

Next, the formation part 100B includes, as an example, a forming mold 102 having a pair of molds (for example, multiple mold blocks made of alloy tool steel, mold plates, mold pillars, and other members assembled together) that are opened and closed by a press device 150. Here, a front view (schematic diagram) of the press device 150 is shown in FIG. 10. Also, a front cross-sectional view (schematic diagram) of the forming mold 102 is shown in FIG. 11.

As shown in FIG. 10, the press device 150 is configured to include a pair of platens 154, 156, multiple tie bars 152 on which the pair of platens 154, 156 are mounted, and a drive device that moves (raises and lowers) the platen 156. Specifically, the drive device is configured to include a drive source (for example, an electric motor) 160 and a drive transmission mechanism (for example, a ball screw or toggle link mechanism) 162 (however, it is not limited thereto). In the present embodiment, the upper platen 154 in the vertical direction is set as a fixed platen (a platen fixed to the tie bar 152), and the lower platen 156 is set as a movable platen (a platen slidably held by the tie bar 152 and moving up and down). However, the present invention is not limited thereto, and may be set upside down, that is, the upper side may be set as a movable platen and the lower side as a fixed platen, or both the upper side and lower side may be set as movable platens (all not shown).

On the other hand, as shown in FIG. 10, the forming mold 102 includes, as a pair of molds arranged between the pair of platens 154, 156 in the press device 150, an upper mold 104 on the upper side in the vertical direction and a lower mold 106 on the lower side. The upper mold 104 is assembled to the upper platen (in the present embodiment, the fixed platen 154), and the lower mold 106 is assembled to the lower platen (in the present embodiment, the movable platen 156). The upper mold 104 and the lower mold 106 approach and separate from each other to perform mold closing and mold opening (the vertical direction (up-down direction) becomes the mold opening and closing direction). In the present embodiment, powder resin is suitably used as the base resin Rm, and the forming mold 102 is configured as a "tableting mold" that forms the sealing resin R by tableting the base resin Rm (powder resin) in the mold closing step. Specifically, the upper mold 104 constitutes a so-called "pestle type," and the lower mold 106 constitutes a so-called "mortar type."

Next, the lower mold 106 of the forming mold 102 will be described in detail. As shown in FIG. 11, the lower mold 106 includes a lower mold chase 110, a cavity piece 126 held thereby, a clamper 128, and the like. The lower mold chase 110 is fixed to the upper surface of a support plate 114 via support pillars 112. A cavity 108 is provided on the upper surface of the lower mold 106 (the surface on the upper mold 104 side). A predetermined amount of base resin Rm is accommodated in this cavity 108.

The clamper 128 is configured in an annular shape to surround the cavity piece 126, and is assembled to be spaced apart (floating) from the upper surface of the support plate 114 and movable up and down via a push pin 122 and a clamper spring 124 (for example, biasing members exemplified by coil springs) (however, the present invention is not limited to this assembly structure). This cavity piece 126 constitutes the inner part (bottom part) of the cavity 108, and the clamper 128 constitutes the side part of the cavity 108. The shape and number of cavities 108 provided in one lower mold 106 are appropriately set (one or multiple).

In addition, the lower mold 106 is provided with suction passages (holes, grooves, etc.) that communicate with a suction device on the upper surface of the clamper 128, at the boundary between the clamper 128 and the cavity piece 126, etc. (not shown). This allows the film F (strip-shaped film) that is carried in with the base resin Rm placed thereon by a resin guard 400 described later to be held by suction on a mold surface 106a including the inner surface of the cavity 108.

In addition, in the present embodiment, a lower mold heating mechanism (not shown) that heats the lower mold 106 to a predetermined temperature is provided. This lower mold heating mechanism includes a heater (for example, an electric wire heater), a temperature sensor, a power source, etc., and heating control is performed by the control calculation part 100E. As an example, the heater is built into the lower mold chase 110 and is configured to apply heat to the entire lower mold 106 and the base resin Rm accommodated in the cavity 108. At this time, the lower mold 106 is heated to a predetermined temperature (for example, 50°C to 80°C) such that the base resin Rm does not thermally cure (fully cure).

The above-described lower mold 106 has a structure with a movable clamper (clamper 128) as an example, but as another example, it may have a structure without a movable clamper (not shown).

Next, the upper mold 104 of the forming mold 102 will be described in detail. As shown in FIG. 11, the upper mold 104 includes a tableting plate 142 that presses a predetermined amount of base resin Rm accommodated in the cavity 108 of the lower mold 106 to make (tablet) it into a sealing resin R having a predetermined shape corresponding to the shape of the workpiece W (details of the formation method will be described later). The tableting plate 142 is held (fixed) to an upper mold chase 140. As an example, a leg part forming groove (including recesses) 143 for forming the leg parts Rb of the sealing resin R are provided on the lower surface (surface on the lower mold 106 side) of the tableting plate 142. The leg part forming groove 143 is provided on the tableting plate 142, but may be provided on the cavity piece 126, or may be provided on both.

Here, the press device 150 is provided with an upper mold film supply part 113 that supplies a film F for covering a mold surface 104a (predetermined region) of the upper mold 104. As an example, the film F is in a roll shape but may be in a strip shape.

In addition, the upper mold 104 is provided with suction passages (holes, grooves, etc.) that communicate with a suction device on the tableting plate 142, etc. (not shown). This allows the film F supplied from the upper mold film supply part 113 to be held by suction on the mold surface 104a.

In addition, in the present embodiment, an upper mold heating mechanism (not shown) that heats the upper mold 104 to a predetermined temperature is provided. This upper mold heating mechanism includes a heater (for example, an electric wire heater), a temperature sensor, a power source, etc., and heating control is performed by the control calculation part 100E. As an example, the heater is built into the upper mold chase 140 and is configured to apply heat to the entire upper mold 104. At this time, the upper mold 104 is heated to a predetermined temperature (for example, 50°C to 80°C) such that the base resin Rm held (accommodated) in the lower mold 106 does not thermally cure (fully cure).

Next, the supply part 100A includes, as an example, a film supply part 165 that supplies film F (strip-shaped film). In addition, it includes a dispenser 166 that supplies (discharges) base resin Rm. In the present embodiment, a resin guard (transport tool) 400 is used for holding the film F (strip-shaped film) and the base resin Rm, and is transported by a loader 168. Multiple resin guards 400 are prepared as appropriate and are configured for circulation use.

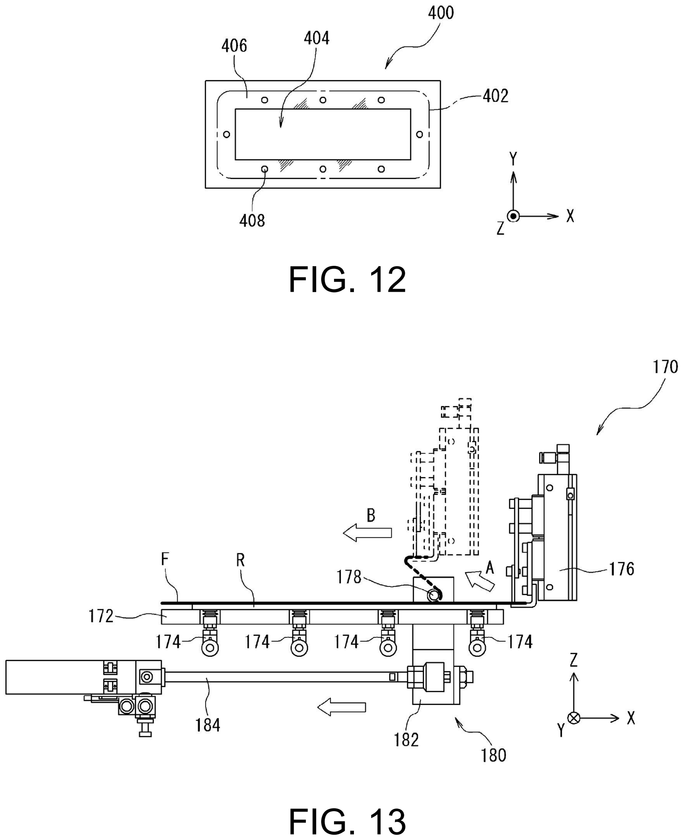

As shown in FIG. 12, the resin guard 400 has an accommodation part 402 that accommodates the base resin Rm. A through hole 404 penetrating in the up-down direction is formed in the accommodation part 402, and suction holes 408 for suctioning the film F are formed in a peripheral part 406 of the through hole 404. According to this configuration, the base resin Rm may be placed and held on the film F in the through hole 404 in a state where the strip-shaped film F is suctioned so as to block the through hole 404 from the lower surface side. The size of the through hole 404 is slightly smaller than the cavity 108 of the forming mold 102. In addition, the thickness of the resin guard 400 is the thickness necessary for transporting the base resin Rm (powder resin) to the cavity 108 of the forming mold 102 for formation.

Next, the storage part 100C includes, as an example, a film peeling mechanism 170 that peels the film F from the sealing resin R formed by tableting the base resin Rm (powder resin). In addition, it includes a storage magazine 192 that stores the sealing resin R after peeling the film F. A known stack magazine or the like may be used for the storage magazine 192. In addition, it includes an inversion mechanism 194 that inverts the sealing resin R such that the upper and lower surfaces are reversed. Moreover, in the case where inversion is not necessary according to the configuration of the forming mold 102, the configuration of the sealing resin R to be formed, etc., the inversion mechanism 194 may be omitted (not shown).

As shown in FIG. 13, the film peeling mechanism 170 includes a suction stage 172 provided with a suction part 174 on one of its upper surface or lower surface that suctions the suctioned surface of the sealing resin R (the surface not covered with the strip-shaped film F) (the sealing resin R is illustrated in a substantially plate shape for simplification of the drawing). According to this configuration, since the sealing resin R may be held on the suction stage 172 without clamping, occurrence of cracking in the sealing resin R due to clamping can be prevented.

In addition, the film peeling mechanism 170 includes a grip part 176 that grips one end of the film F and moves toward the other end. According to this configuration, the film F may be peeled from the sealing resin R in a state of being suctioned and held on the suction stage 172. As an example, the mechanism for gripping the film F uses gripping claws, but is not limited thereto, and may use suction pads or the like (not shown).

In addition, the film peeling mechanism 170 includes a tension roller 178 that linearly moves in the same direction as the movement direction of the grip part 176 while applying tension to the film F by bringing the film F into rolling contact (or sliding contact) with a part of the peripheral surface in the case of the grip part 176 gripping one end of the film F and moving toward the other end. The grip part 176 may wrap around the tension roller 178 by sandwiching the film end and then moving the grip part 176 in an obliquely upward peeling direction.

As an example, the grip part 176 and the tension roller 178 are arranged on the same side as the surface where the suction force by the suction part 174 occurs with respect to the suction stage 172. In addition, the tension roller 178 is arranged such that the center axis is orthogonal to the linear movement direction.

Furthermore, the film peeling mechanism 170 has a support part 182 that rotatably supports the tension roller 178, and includes a tension part 180 that applies resistance so as to restrict the linear movement of the tension roller 178.

As an example, the tension part 180 includes a linear motion mechanism 184 using an air cylinder (a mechanism that linearly moves the support part 182 in the same direction as the grip part 176), and the above-mentioned "resistance" is configured to be set by the linear motion mechanism 184 (for example, by sliding resistance or operating force). Moreover, the sliding resistance of atmosphere exhaust air alone sufficient, but the exhaust pressure may also be controlled. Alternatively, as another example, a configuration including a linear motion mechanism using an electric motor and a ball screw or the like may be adopted (not shown). In any of the above examples, instead of a configuration in which the "resistance" is set constant, a configuration in which variable control is performed by the control calculation part 100E may be adopted.

According to this configuration, in the case of peeling the film F from the sealing resin R, appropriate tension that is not too strong may be applied to the film F, so occurrence of cracking in the sealing resin R due to strong tension can be prevented.

### (Formation Method of Sealing Resin)

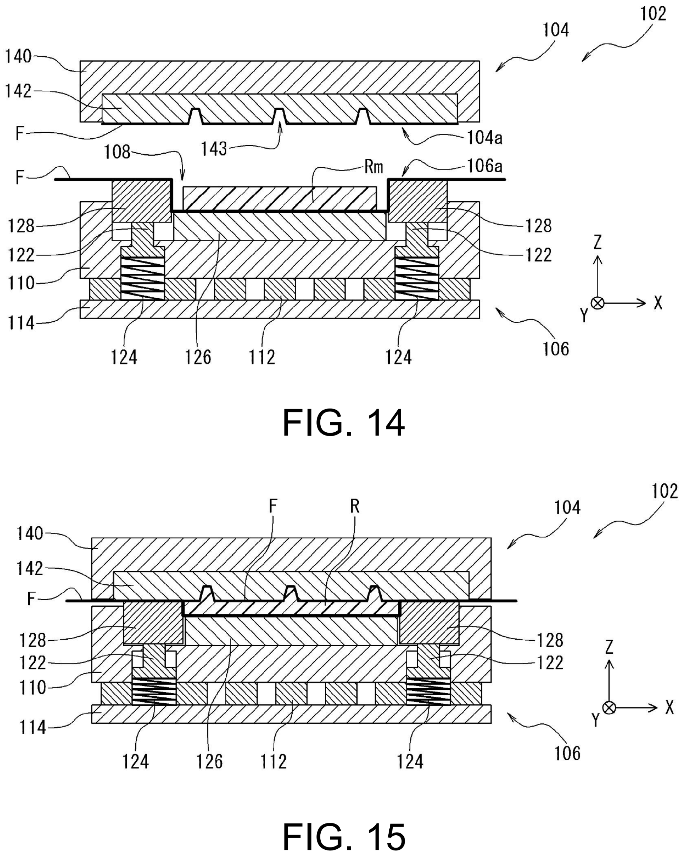

Next, the steps of the formation method of sealing resin according to the present embodiment implemented using the above formation device 100 will be described. Here, FIG. 14 to FIG. 16 are explanatory diagrams of each step, and are illustrated as front cross-sectional views in the same direction as FIG. 11.

First, a preparation step (tableting preparation step) is implemented. The preparation step has the following steps. A lower mold heating step is implemented in which the lower mold 106 is adjusted to a predetermined temperature (a temperature at which the base resin Rm and sealing resin R do not fully cure, for example, 50°C to 80°C) and heated by the lower mold heating mechanism. In addition, an upper mold heating step is implemented in which the upper mold 104 is adjusted to a predetermined temperature (a temperature at which the base resin Rm and sealing resin R do not fully cure, for example, 50°C to 80°C) and heated by the upper mold heating mechanism. In addition, an upper mold film supply step is implemented in which the upper mold film supply part 113 is operated to supply a new film F and cause suction so as to cover a predetermined region of the mold surface 104a of the upper mold 104.

After the preparation step, the film F is held by suction so as to block the through hole 404 of the resin guard 400. In that state, the base resin Rm is supplied (discharged) from the dispenser 166 onto the film F. Next, a setting step is implemented in which the film F and base resin Rm held by the resin guard 400 are transported by the loader 168, and the film F and base resin Rm are set at a predetermined position of the forming mold 102 (in this case, so as to be accommodated in the cavity 108 of the lower mold 106) (see FIG. 14). Moreover, the resin guard 400 after setting the film F and base resin Rm is returned to the supply part 100A by the loader 168.

After the setting step, a formation step is implemented in which the base resin Rm is heated and pressurized with the film F interposed in the forming mold 102 to form the sealing resin R having a predetermined shape. The formation step according to the present embodiment includes a tableting step that forms a solid/semi-solid resin having a "predetermined shape" (details described later) corresponding to the shape of the workpiece W as the sealing resin R by tableting the base resin Rm. Specifically, a step (mold closing step) is implemented in which the press device 150 is operated to perform mold closing of the forming mold 102 heated to the above predetermined temperature (see FIG. 15). At this time, the cavity piece 126 relatively rises within the cavity 108, and the base resin Rm is tableted (sandwiched and pressurized) by the cavity piece 126 and the tableting plate 142. As a result, a solid/semi-solid sealing resin R having a predetermined shape and not thermally cured (fully cured) is formed. At this time, the base resin Rm that enters the leg part forming groove 143 of the tableting plate 142 via the film F becomes the leg part Rb of the sealing resin R, and the other (remaining) base resin Rm becomes the main body part Ra of the sealing resin R (the detailed configuration of the sealing resin R will be described later). Moreover, as a modification example of the tableting step, a part of the base resin Rm may be held (welded, gripped, etc.) by the upper mold 104 (not shown).

Moreover, the above tableting step is implemented at a temperature at which the base resin Rm does not thermally cure (fully cure) (by heating the lower mold 106 and upper mold 104 to a temperature at which thermal curing (full curing) does not occur) such that the formed sealing resin R may thermally cure (fully cure) in the resin sealing step (one step of the compression molding method) implemented later in the compression molding device 1. As described above, the "temperature at which thermal curing does not occur" depends on the material of the base resin Rm, but as a specific example, it is approximately 50°C to 80°C (in the present embodiment, it is approximately 70°C).

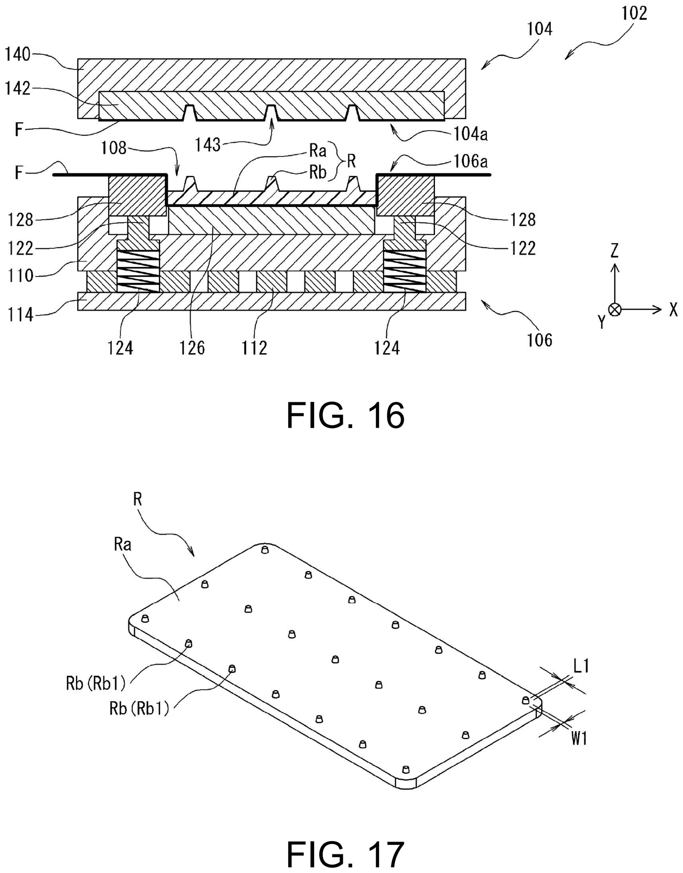

Here, the "predetermined shape" of the sealing resin R will be described. As an example, in the case of the sealing resin R used in the compression molding device 1 including the sealing mold 202, the "predetermined shape" is a shape that does not contact the electronic components Wb (electronic components Wb having wires include the wires) when placed on the base material Wa of the workpiece W. As an example, as shown in FIG. 2, the sealing resin R having a shape provided with a plate-shaped or block-shaped main body part Ra and leg parts Rb erected intermittently (or continuously) on one surface of the main body part Ra (the surface facing the electronic components Wb of the workpiece W) is suitable (however, it is not limited to this shape). The main body part Ra has a size that fits into the cavity 208 in plan view, and considering resin flow, a size slightly smaller than the shape of the cavity 208 (particularly, the cavity piece 226) is suitable. In addition, the leg parts Rb require a height H (see FIG. 3A) that does not contact the electronic components Wb, but this does not exclude contact to the extent that the wires do not plastically deform. In addition, the leg parts Rb are arranged at positions that do not contact the electronic components Wb in plan view of the main body part Ra and at positions where the main body part Ra does not tilt when placed on the base material Wa of the workpiece W. Furthermore, a configuration arranged between the electronic components Wb or at the outer peripheral positions of the electronic components Wb is suitable so as not to damage the wiring (particularly, wires) of the workpiece W even slightly during molding. Moreover, the total resin amount of the plate-shaped or block-shaped main body part Ra and the leg parts Rb may be a resin amount to the extent that it is not insufficient for one compression molding, without excess or deficiency, or may be a large resin amount. Details of specific configuration examples (FIG. 17 to FIG. 20) of the sealing resin R will be described later.

As another example, in the case of the sealing resin R used in the compression molding device 1 including the sealing mold 302, the "predetermined shape" is a shape in which, in response to mold closing of the sealing mold 302, the upper mold 304 is gradually brought closer to the lower mold 306, and in a state where the tips (upper ends) of the leg parts Rb of the sealing resin R accommodated in the cavity 308 contact the base material Wa of the workpiece W held by the workpiece holding part 305, the main body part Ra of the sealing resin R does not contact the electronic components Wb of the workpiece W (electronic components Wb having wires include the wires). Moreover, the specific shape of the sealing resin R is the same as in the case of the sealing resin R used in the compression molding device 1 including the sealing mold 202 described above (see FIG. 17 to FIG. 20), so repeated description will be omitted. However, the sealing resin R is not limited to the configurations shown in FIG. 17 to FIG. 20, and may have a configuration in which the upper surface is formed flat without providing leg parts Rb on the upper surface (not shown).

Next, a resin amount setting step for setting the "predetermined amount" of the base resin Rm will be described. As an example of the resin amount setting step, for each workpiece W to be sealed, the control calculation part 100E acquires data measured by a measurement mechanism or the like (not shown) regarding the number of presence or absence of electronic components Wb mounted on one base material Wa (mounting number or missing number, and may further include cases of measuring individual heights of electronic components Wb and cases of measuring thickness of base material Wa and weight of workpiece W). Next, the control calculation part 100E calculates the resin amount (number of grams) necessary for resin sealing (compression molding) for each workpiece W based on the measurement data. Alternatively, as another example of the resin amount setting step, multiple types of standard amounts corresponding to types of workpieces W to be sealed are prepared, and the control calculation part 100E or an operator selects an optimal one according to the type of workpiece W from among the standard amounts to set the "predetermined amount". In the case of standard amounts, it is important that the resin amount does not become insufficient during resin sealing (during compression molding). With either setting, an appropriate amount of base resin Rm may be supplied to the workpiece W. Therefore, particularly, occurrence of molding defects caused by insufficient resin amount necessary during resin sealing can be prevented. Furthermore, occurrence of waste due to supply of excessive resin amount beyond necessity can be prevented.

Also, it is preferable that powder resin is used as the base resin Rm. According to this, compared to cases where granular resin or crushed resin is used, the resin of the supply amount may be supplied with extremely accurate adjustment. However, it is not limited to powder resin.

After the tableting step, a mold opening step is implemented in which mold opening of the forming mold 102 is performed to separate the sealing resin R from the used film F (roll-shaped film F stuck to the first surface of the sealing resin R) such that the sealing resin R may be taken out (see FIG. 16). For convenience of explanation, in the sealing resin R, the surface formed under pressure by the upper mold 104 is referred to as the "first surface," and the surface formed under pressure by the lower mold 106 is referred to as the "second surface."

After the mold opening step, or in parallel, an upper mold film supply step is implemented in which the upper mold film supply part 113 is operated to send out the used film F (roll-shaped film) for the upper mold 104 from inside the forming mold 102, and send new film F into the forming mold 102 and set it on the upper mold 104 (mold surface 104a).

Also, after the mold opening step, a removal step is implemented in which the sealing resin R is carried out from inside the forming mold 102 by the loader 169 and transported to the storage part 100C. In the present embodiment, it is transported to the storage part 100C in a state where the used film F (strip-shaped film) for the lower mold 106 is stuck to the second surface of the sealing resin R.

After the removal step, a peeling step is implemented to peel the film F (strip-shaped film F stuck to the second surface of the sealing resin R) from the sealing resin R. In the present embodiment, first, an inversion step is implemented to invert the sealing resin R up and down using the inversion mechanism 194. According to this, the second surface of the sealing resin R to which the strip-shaped film F is stuck may be directed upward, and the first surface to which the strip-shaped film F is not stuck may be directed downward. In the case where inversion is not necessary, the above inversion step may be omitted.

After the inversion step, the sealing resin R (with the first surface facing downward) is placed on the suction stage 172. Next, suction force is generated by the operation of the suction part 174, and the sealing resin R is suctioned and held on the suction stage 172 (the first surface becomes the suctioned surface). Next, the grip part 176 grips (clamps) one end of the film F and moves toward the other end. More specifically, the grip part 176 that grips one end of the film F first moves diagonally upward (in the direction of an arrow A), and then moves horizontally (in the direction of an arrow B) (see FIG. 13). Through these operations, the film F (strip-shaped film) may be peeled from the sealing resin R (second surface).

Here, in response to the grip part 176 moving, the film F is brought into rolling contact (or sliding contact) with a part of the peripheral surface of the tension roller 178, and the tension roller 178 moves linearly in the same direction as the movement direction of the grip part 176 (the movement distance of the grip part 176 is longer than that of the tension roller 178). At this time, the tension part 180 applies movement resistance of the tension roller 178 (resistance that acts to suppress linear movement, that is, force that acts in the direction opposite to the movement direction). As described above, the resistance is configured to be set constant by the sliding resistance and operating force of the linear motion mechanism 184, but as a modification example, it may be configured to be variably controlled by the control calculation part 100E, that is, configured to be able to appropriately change the resistance according to the materials of the sealing resin R and the film F.

As described above, the sealing resin R before full curing has low rigidity (is brittle) and weak strength, so there was an issue that cracking easily occurs. In response to this issue, according to the above configuration, the sealing resin R may be held on the suction stage 172 without clamping, so occurrence of cracking in the sealing resin R can be prevented. Furthermore, since appropriate tension that is not too strong may be applied to the film F in response to peeling the film F, occurrence of cracking in the sealing resin R can be prevented.

After the peeling step, the peeled film F (strip-shaped film) is discarded to a disposer (not shown). Also, the sealing resin R is stored in the storage magazine 192.

The above are the main steps of the formation method of the sealing resin R performed using the formation device 100. However, the above step sequence is an example, and changes in the order or parallel implementation are possible as long as there is no hindrance.

### (Sealing Resin)

Next, specific configuration examples of the sealing resin R formed by the above formation device 100 and formation method are shown in FIG. 17 to FIG. 20, and the features of each are described.

First, as a configuration common to each example shown in FIG. 17 to FIG. 20, the main body part Ra is formed in a plate shape (it may also be a shape other than a plate shape, for example, a block shape having recesses or protrusions, etc.). Also, the leg part Rb is erected on the main body part Ra so as to be at a position where it does not contact the electronic components Wb of the workpiece W in response to the sealing resin R being placed at a predetermined position (design setting position) on the base material Wa of the workpiece W, and is formed to a height H (see FIG. 3A, etc.) capable of ensuring a distance where the main body part Ra does not contact the electronic components Wb. As described above, in the tableting step, the base resin Rm that enters into the leg part forming groove 143 of the tableting plate 142 via the film F becomes the leg part Rb of the sealing resin R, and the other (remaining) base resin Rm becomes the main body part Ra of the sealing resin R.

In the example of the sealing resin R shown in FIG. 17, the leg part Rb is formed as a convex body Rb1 in which all (or may be a part) are arranged in a dot-like manner. As an example of the convex body Rb1, multiple convex bodies are arranged at multiple positions and formed in a shape where the ratio t of a length L1 to a width W1 in plan view is 0.5 ≦ t ≦ 2 as an example. According to this, by the configuration where the leg part Rb is columnar arranged in a dot-like manner, the sealing resin R placed on the workpiece W can be suppressed from flowing during compression molding. Therefore, wire flow and the like can be prevented, and molding quality can be improved.

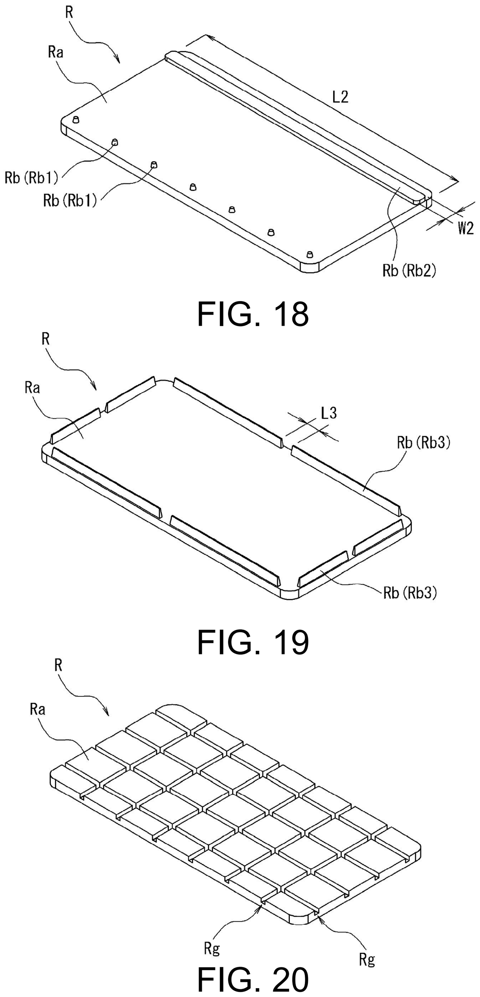

In the example of the sealing resin R shown in FIG. 18, the leg part Rb is formed as a convex body Rb2 in which a part (or may be all) is arranged in a linear manner. As an example of the convex body Rb2, it is arranged at one position (or may be multiple positions) and formed in a shape where the ratio t of a length L2 to a width W2 in plan view is t<0.5 or 2<t as an example. According to this, resin flow may be intentionally generated from the leg part Rb (in this case, the convex body Rb2) having a bank-like configuration of predetermined length, and filling of the sealing resin R into narrow portions in the workpiece W (for example, between the base material Wa and the electronic components Wb that are flip-chip connected, etc.) can be promoted. Therefore, gas remaining in the molded product Wp can be prevented, and molding quality can be improved.

In the example of the sealing resin R shown in FIG. 19, the leg part Rb is formed as a convex body Rb3 arranged to surround intermittently (or may be continuously) over the entire area (entire circumference) of the outer periphery (referring to the outer edge region) of the main body part Ra. As an example of the convex body Rb3, convex bodies having the same configuration as the above Rb2 are formed in a continuous manner to form a circumferential shape while providing gaps L3 at predetermined intervals. Generally, the outer peripheral position of the sealing resin R in the molded product Wp is a position that is cut by a dicer or the like during singulation, and since the electronic components Wb do not exist there, a larger amount of resin is required for sealing compared to the central position. Therefore, by providing the leg part Rb (in this case, the convex body Rb3) arranged to surround the entire outer periphery as in this configuration, it becomes possible to supply a large amount of resin to the outer peripheral position while suppressing resin flow during compression molding. Furthermore, by providing the gaps L3, discharge of gas components such as air from the inside (central part) to the outside is promoted.

On the other hand, the example of the sealing resin R shown in FIG. 20 is a configuration example regarding the other surface of the main body part Ra (the surface on the side where the leg part Rb is not provided, that is, the surface on the side not facing the electronic components Wb of the workpiece W). Specifically, the main body part Ra has linear groove parts Rg formed on the other surface at positions where dicing for singulation is performed. According to this, reduction of wear of the dicing blade and reduction of dust generated during dicing can be achieved. As an example, the groove parts Rg are provided in a lattice pattern to match the dicing positions, but the present invention is not limited thereto. In order to form the groove parts Rg, the tableting step may be performed using a cavity piece 126 having protrusions (not shown) of corresponding shape provided on the upper surface.

As described above, according to the formation device 100 of the present invention, in response to peeling the film F attached to the sealing resin R during the formation process, the sealing resin R may be held without clamping. Furthermore, the peeling operation of the film F may be performed while applying appropriate tension to the film F that is not too strong. Therefore, occurrence of cracking can be prevented in the sealing resin R before full curing.

Furthermore, by using the sealing resin R formed by the formation device 100 and the formation method, a compression molding device 1 and compression molding method that achieve the following effects can be realized. Specifically, the compression molding device 1 and compression molding method can prevent occurrence of molding defects caused by resin flow, scattering unevenness, residual gas, and dust generation during molding. Moreover, not only thin molded products Wp (thickness dimension less than 1 mm) but also thick molded products Wp (thickness dimension 1 mm or more) may be formed. The upper limit of the thickness dimension is considered to be sufficiently formable up to about 10 mm, although it depends on various setting conditions. Furthermore, handling during supply and setting becomes easy.

Furthermore, the compression molding device 1 and compression molding method can solve problems that occur in configurations where a cavity is provided in an upper mold. That is, in conventional compression molding devices where a cavity is provided in an upper mold, for example, in the case of performing a mold closing step on a workpiece W or the like on which strip type wire-connected electronic components (semiconductor chips) Wb are mounted, the wire portions of the workpiece held by the lower mold come into contact with the sealing resin supplied in advance to the cavity or the sealing resin supplied on the workpiece, causing deformation and cutting, which makes resin sealing difficult. To address this problem, a solution can be achieved by adopting a configuration that uses the sealing resin R formed by the device and method according to the present embodiment, that is, solid or semi-solid resin formed into a predetermined shape corresponding to the shape of the workpiece W.

Specifically, during the mold closing step, softening and melting of the sealing resin R by heating progresses as shown in the transition from FIG. 3A to FIG. 3B. At this time, the resin (specifically, the main body part Ra) comes into contact uniformly with all wires (see FIG. 3B). Therefore, it becomes possible to prevent deformation and cutting of the wires.

Furthermore, in the case of actually conducting experiments using the sealing resin R formed by the device and method according to the present embodiment in the compression molding device 1 described above, compared to conventional compression molding devices having a configuration where the workpiece W is held by an upper mold, a cavity is provided in a lower mold, and sealing resin (specifically, granular resin) is supplied to the cavity, results confirming that deformation and cutting of wires were prevented and molding quality was improved were obtained.

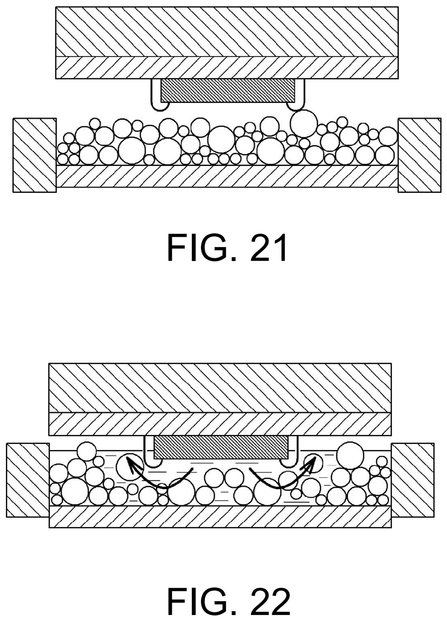

On the other hand, the compression molding device 1 and compression molding method can also solve problems that occur in the case of a configuration where a cavity is provided in a lower mold. That is, in conventional compression molding devices where a cavity is provided in a lower mold, particularly in the case of using granular resin as sealing resin, the particle size and height (stacking thickness) of the sealing resin (granular resin) accommodated in the cavity do not become uniform. Therefore, for example, depending on the type and melting state of the granular resin, it may not be completely liquid (low viscosity state), and in the case of implementing a mold closing step for a workpiece W or the like on which strip type wire-connected electronic components (semiconductor chips) Wb are mounted, as shown in FIG. 21, depending on the position, the wire portion of the workpiece held by the upper mold may partially contact strongly (largely) with the sealing resin (granular resin) and become deformed or cut. Furthermore, as shown in FIG. 22, there was a problem that large resin flow occurred within the cavity, causing deformation and cutting of the wire portion. To address this problem, a solution can be achieved by adopting a configuration using the sealing resin R formed by the device and method according to the present embodiment, that is, solid or semi-solid resin formed into a predetermined shape corresponding to the shape of the workpiece W.

Specifically, this is for the same reason as explained by FIG. 3A and FIG. 3B above, and during the mold closing step, softening and melting of the sealing resin R progresses due to heating, resulting in a state where the resin (specifically, the main body part Ra) uniformly contacts all wires. From that perspective, the sealing resin R is not limited to the configurations shown in FIG. 17 to FIG. 20, and may have a configuration (not shown) where the upper surface is formed flat without providing leg parts Rb on the upper surface. Even with this configuration, compared to conventional technology using granular resin, it becomes possible to solve problems caused by non-uniformity in particle size and height (stacking thickness).

Also, by making the formation device 100 a separate device from the compression molding device 1, the compression molding device 1 may be made unaffected by dust generated during tableting of powder resin in the formation device 100, and the compression molding device 1 may be easily placed in a clean room. However, the configuration is not limited thereto, and a configuration where the formation device 100 is integrally installed within the compression molding device 1 may also be adopted.

Moreover, the present invention is not limited to the above embodiments, and various modifications are possible within the scope that does not depart from the present invention.

## Claims

1. A sealing resin formation device, which is a formation device that forms a sealing resin used for compression molding of a workpiece, the sealing resin formation device comprising:
a forming mold that has a pair of lower mold and upper mold that are opened and closed, and that accommodates, and heats and pressurizes a base resin in a state where a release film is interposed, so as to form the sealing resin of a predetermined shape; and
a film peeling mechanism that peels the release film from the formed sealing resin.

2. The sealing resin formation device according to claim 1,
wherein a powder resin is used as the base resin, and
the forming mold is a tableting mold that tablets the powder resin.

3. The sealing resin formation device according to claim 1 or claim 2,
wherein the forming mold is set to a heating temperature at which the base resin does not thermally cure, such that the formed sealing resin is capable of thermal curing in a case of being used for compression molding of the workpiece.

4. The sealing resin formation device according to claim 1 or claim 2,
wherein the film peeling mechanism comprises a grip part that grips one end of the release film and moves toward the other end.

5. The sealing resin formation device according to claim 4,
wherein the film peeling mechanism comprises a tension roller that, in response to the grip part gripping the one end of the release film and moving toward the other end, brings the release film into rolling contact or sliding contact with a part of a peripheral surface to apply tension to the release film while performing a linear movement in a same direction as a movement direction of the grip part.

6. The sealing resin formation device according to claim 5,
wherein the film peeling mechanism comprises a tension part that rotatably supports the tension roller and applies resistance to restrict the linear movement of the tension roller.

7. The sealing resin formation device according to claim 6,
wherein the tension part is configured to comprise a linear motion mechanism using an air cylinder or an electric motor, and the resistance is set by the linear motion mechanism or is variably controlled.

8. The sealing resin formation device according to claim 5,
wherein the film peeling mechanism comprises a suction stage provided with a suction part that suctions the sealing resin on one of an upper surface or a lower surface, and
the grip part and the tension roller are arranged on a same side as a surface on which the suction part is provided with respect to the suction stage.

9. The sealing resin formation device according to claim 1 or claim 2, further comprising:
an inversion mechanism that inverts the sealing resin such that an upper and a lower surface of the sealing resin are reversed.
